# FASCICULE DE BREVET EUROPEEN

(11) **EP 4 423 864 B1**
(45) Date de publication et mention de la délivrance du brevet: **14.05.2025**
(21) Numéro de dépôt: 22801479.1
(22) Date de dépôt: 13.10.2022
(51) Int. Cl.: H01S 5/02, H01S 5/0239, H01S 5/024, H01S 5/026, H01S 5/042, H01S 5/10

(54) **DISPOSITIF PHOTONIQUE POURVU D'UNE SOURCE LASER ET DE MOYENS DE GESTION DE LA DISSIPATION DE CHALEUR**
PHOTONISCHE VORRICHTUNG MIT EINER LASERQUELLE UND MITTELN ZUR VERWALTUNG DER WÄRMEABLEITUNG
PHOTONIC DEVICE PROVIDED WITH A LASER SOURCE AND MEANS FOR MANAGING DISSIPATION OF HEAT

(30) Priorité: 29.10.2021 FR 2111534; 07.12.2021 FR 2113081
(43) Date de publication de la demande: 04.09.2024
(73) Titulaire: Scintil Photonics, 38040 Grenoble (FR)
(72) Inventeur: MENEZO, Sylvie, 38040 Grenoble (FR); MAZUR, Frédéric, 38040 Grenoble (FR)
(74) Mandataire: IP Trust
(86) Numéro de dépôt international: PCT/EP2022/078525
(87) Numéro de publication internationale: WO 2023/072610

(56) Documents cités:
- FR-A1- 3 007 589
- FR-A1- 3 023 066
- US-A1- 2017 299 809
- US-B1- 10 651 110
- ZHANG CHONG ET AL: "Thermal Management of Hybrid Silicon Ring Lasers for High Temperature Operation", IEEE JOURNAL OF SELECTED TOPICS IN QUANTUM ELECTRONICS, IEEE, USA, vol. 21, no. 6, 1 November 2015 (2015-11-01), pages 1 - 7, XP011585819, ISSN: 1077-260X, [retrieved on 20150626], DOI: 10.1109/JSTQE.2015.2428057

## Description

### DOMAINE DE L'INVENTION

La présente invention se rapporte aux domaines de la microélectronique, de l'optique, de l'électro-optique et de la photonique. L'invention concerne notamment un dispositif photonique pourvu d'au moins une source laser à semi-conducteurs III-V intégrée dans un substrat de silicium et pourvu de moyens de dissipation thermique dont l'agencement permet une dissipation thermique plus efficace, au regard des agencements connus de l'homme du métier.

La présente invention propose un dispositif permettant de fournir l'alimentation électrique à un ou plusieurs lasers intégrés sur un support par exemple en silicium, tout en améliorant la dissipation thermique des lasers vers une plaque de dissipation thermique.

### ARRIERE PLAN TECHNOLOGIQUE DE L'INVENTION

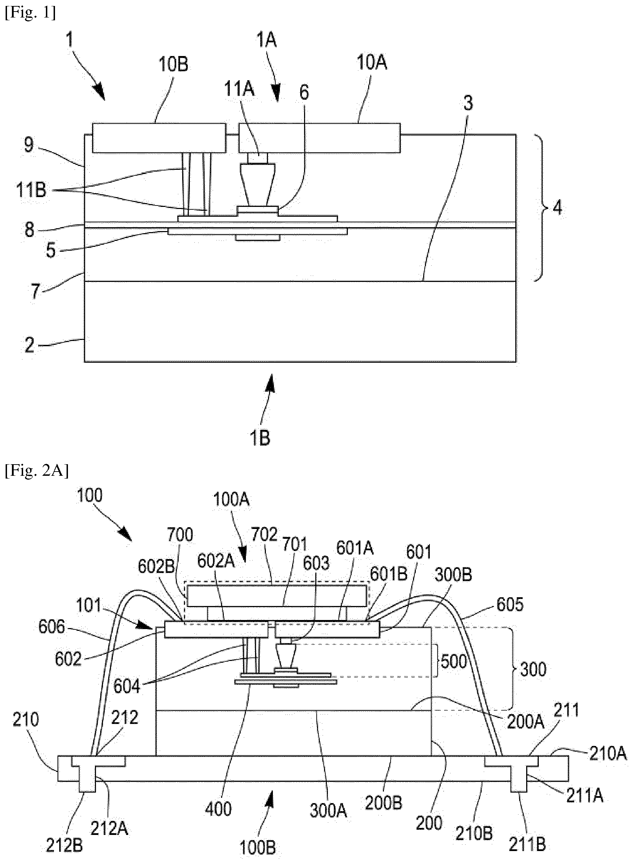

Le document [1] cité à la fin de la description divulgue un dispositif 1 laser hétérogène. Ce dispositif 1, tel qu'illustré à la [Fig.1], comprend, d'une face arrière 1B vers une face avant 1A, un substrat support 2, notamment fait de silicium, sur une face principale 3 duquel repose une couche photonique 4.

Notamment, la couche photonique 4 comprend au moins une couche de matériau diélectrique et dans laquelle sont encapsulés un guide d'onde 5 et un empilement photonique 6 formé d'une pluralité de couches de matériaux semi-conducteurs III-V structurées en un deuxième guide d'onde. Plus particulièrement, l'empilement photonique 6 et le guide d'onde 5 sont optiquement couplés de manière à former une source laser hétérogène.

Plus particulièrement, la couche photonique 4, telle que représentée à la [Fig.1], comprend, à partir de la face principale 3, un empilement de trois couches, dites, respectivement, première couche 7, deuxième couche 8 et troisième couche 9. A cet égard, le guide d'onde 5 peut être disposé dans la première couche 7 et en affleurement avec l'interface formée entre la première couche 7 et la deuxième couche 8, tandis que l'empilement photonique 6, à l'aplomb du guide d'onde 5, peut être disposé dans la troisième couche 9 et en affleurement avec l'interface formée entre la deuxième couche 8 et la troisième couche 9.

Par ailleurs, le dispositif 1 représenté à la [Fig.1] comprend également des moyens d'interconnexion pourvus de plots de contact 10A et 10B accessibles par la face avant 1A et électriquement connectés à l'empilement photonique 6 au moyen de vias de connexion 10A et 10B qui s'étendent dans la couche photonique 4 et plus particulièrement dans la troisième couche 9.

Ainsi, dès lors qu'une tension est imposée à chacun des plots de contact, l'empilement photonique est susceptible d'émettre un rayonnement laser. Ce rayonnement laser est guidé dans le guide d'onde 5 et l'empilement photonique 6, et peut, selon la configuration du dispositif 1, être injecté dans une fibre optique ou un autre dispositif photonique par l'intermédiaire de moyens de couplage formés dans le dispositif 1.

Aussi, afin d'assurer un confinement optimal du rayonnement laser dans le guide d'onde, et par voie de conséquence limiter les pertes optiques, la couche photonique est généralement formée de couches diélectriques 7, 9 d'épaisseurs relativement importantes, par exemple de l'ordre de 800 nm, voire supérieures.

Hors, en fonctionnement, l'empilement photonique 6 subit un échauffement qui, s'il n'est pas maitrisé, est susceptible d'affecter les performances du dispositif 1 et plus particulièrement de la source laser. Les couches diélectriques formant la couche photonique constituent à cet égard un obstacle à la dissipation thermique et viennent, par voie de conséquence, exacerber cet échauffement.

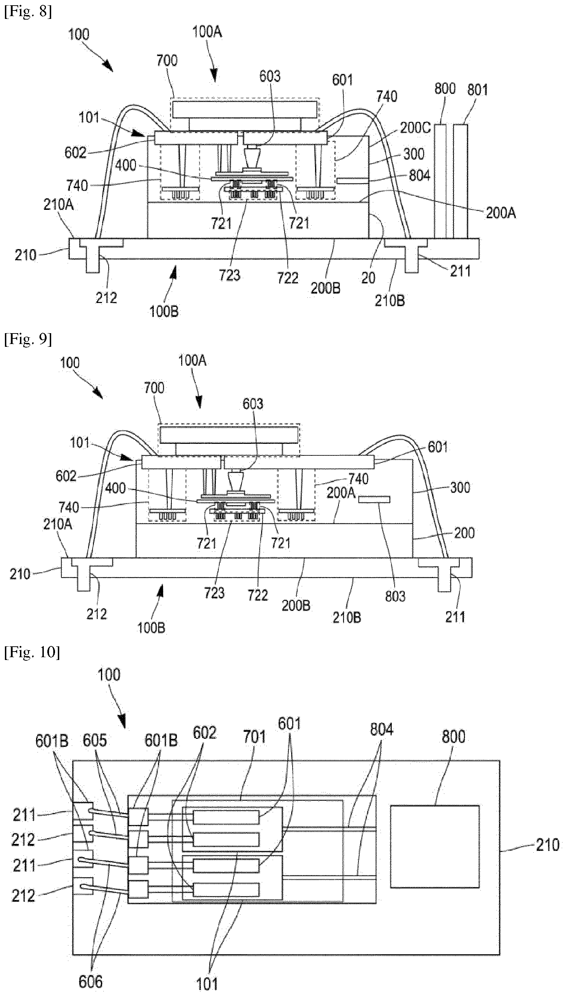

Le document [2] cité à la fin de la description propose également un dispositif laser hétérogène. Notamment, ce dispositif laser comprend (conformément à la [Fig.9] du document [2]) un substrat de silicium sur une face duquel reposent, dans l'ordre, une couche de dioxyde de silicium, une couche de silicium, et un empilement photonique. L'empilement photonique, à l'instar de celui proposé dans le document [1], est formé d'une pluralité de couches de matériaux semi-conducteurs III-V structurées en un guide d'onde, dit guide laser. Le guide laser est à cet égard couplé avec un guide d'onde formé dans la couche de silicium. Ce dispositif comprend également des moyens de dissipation thermique configurés pour dissiper la chaleur susceptible d'être produite par l'empilement photonique. Plus particulièrement, lesdits moyens comprennent des ponts de silicium poly cristallin formés à l'aplomb de l'empilement photonique et configurés pour dissiper la chaleur produite par l'empilement photonique vers le substrat de silicium.

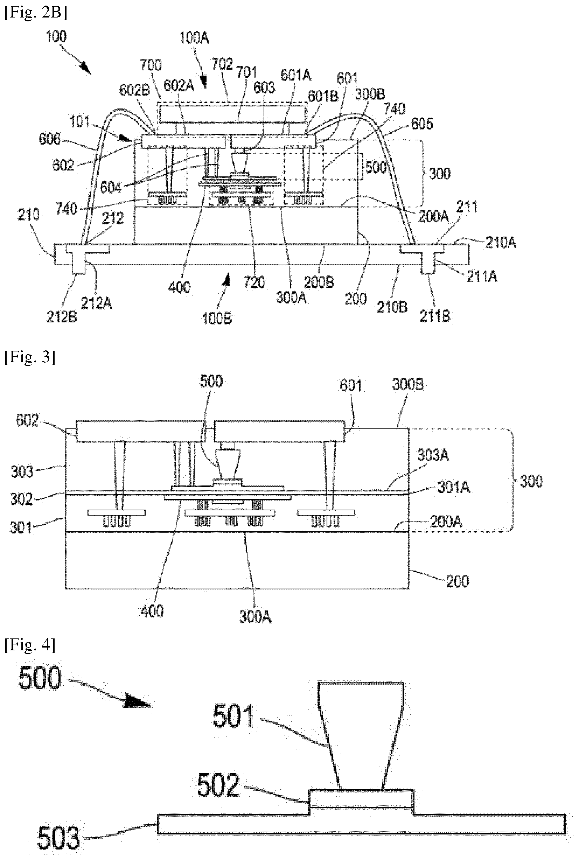

Le document [3] cité à la fin de la description propose une autre architecture afin de maîtriser la dissipation thermique. Plus particulièrement, et tel qu'illustré à la [Fig.4](j) du document [3], le dispositif laser hétérogène comprend des ponts thermiques faits de métal, et reliant thermiquement le substrat de silicium avec les plots de contact de l'empilement photonique.

Enfin le document [4] cité à la fin de la description divulgue également un dispositif photonique pourvu de moyens de dissipation thermique configurés pour dissiper la chaleur produite par un empilement photonique. Notamment, l'empilement photonique est formé d'une pluralité de couches de matériaux semi-conducteurs III-V structurées en un guide d'onde, dit guide laser. Le guide laser est à cet égard couplé avec un guide d'onde formé à l'aplomb dudit guide laser. Dans l'architecture proposée, les moyens de dissipation thermique comprennent des niveaux métalliques encapsulés dans une couche diélectrique reposant sur une face d'un substrat support et permettent de dissiper la chaleur produite par l'empilement photonique vers un substrat support.

Néanmoins, l'efficacité des solutions proposées dans ces documents reste limitée.

Par conséquent, un but de la présente invention est de proposer un dispositif laser hétérogène pourvu de moyens de dissipation thermique dont l'efficacité est améliorée au regard des solutions connues de l'état de la technique.

### BREVE DESCRIPTION DE L'INVENTION

L'invention concerne un dispositif photonique comprenant une puce photonique et un substrat support, la puce photonique comprenant une couche support et une couche photonique reposant par sa face, dite inférieure, sur une face principale de la couche support, ladite couche photonique, qui comprend au moins un matériau diélectrique, encapsule au moins une source laser formée par un guide d'onde et un empilement photonique optiquement couplés entre eux, l'empilement photonique étant constitué de matériaux semi-conducteurs III-V, la puce photonique comprend également un premier et un deuxième plot métallique présentant, respectivement, une première et une deuxième surface, accessibles par une face supérieure de la couche photonique opposée à la face inférieure, et électriquement connectés à l'empilement photonique au moyen de vias de connexion qui s'étendent dans la couche photonique, le premier plot et le deuxième plot sont configurés pour permettre la circulation d'un courant électrique dans l'empilement photonique afin de commander l'émission d'un rayonnement laser par la source laser, le dispositif photonique comprend en outre :
- des premiers moyens de dissipation thermique configurés pour dissiper la chaleur susceptible d'être émise par la source laser, les premiers moyens comprennent une couche de transfert et un élément de transfert en contact thermique avec la couche de transfert, la couche de transfert comprend un matériau électriquement isolant qui est en recouvrement au moins partiel d'au moins l'une de la première et de la deuxième surface;
- des moyens de connexion configurés pour connecter électriquement le premier plot et le deuxième plot avec un premier terminal et un deuxième terminal disposés sur l'un ou l'autre du substrat support et de la couche de transfert.

Selon un mode de mise en œuvre, la couche de transfert est au contact du premier plot et du deuxième plot.

Selon un mode de mise en œuvre, la couche de transfert est faite d'un matériau, dit matériau de transfert, qui présente une conductibilité thermique supérieure ou égale à 20 W/m/K, la couche de transfert comprenant avantageusement au moins un des matériaux choisis parmi : un matériau polymère, de l'AlN ou du silicium.

Selon un mode de mise en œuvre, le guide d'onde est en silicium, ou en nitrure de silicium ou de forme hybride en nitrure de silicium et en silicium.

Selon un mode de mise en œuvre, ledit dispositif photonique comprend également des deuxièmes moyens configurés pour dissiper de la chaleur susceptible d'être émise par la source laser vers le support, les deuxièmes moyens comprennent des seconds vias qui s'étendent, en direction de la face principale, et à partir du guide d'onde.

Selon un mode de mise en œuvre, les deuxièmes moyens comprennent également un insert métallique de forme généralement plane et s'interposant entre les seconds vias et la face principale, les deuxièmes moyens comprennent en outre des seconds vias terminaux qui s'étendent de l'insert métallique vers la face principale, un insert additionnel est avantageusement intercalé entre la face principale et les seconds vias terminaux.

Selon un mode de mise en œuvre, ledit dispositif photonique comprend également des troisièmes moyens configurés pour dissiper de la chaleur susceptible d'être émise par la source laser, les troisièmes moyens comprennent des troisièmes vias qui s'étendent, en direction de la face principale, et à partir, respectivement, du premier plot et du deuxième plot.

Selon un mode de mise en œuvre, les troisièmes moyens comprennent également deux inserts métalliques dits, respectivement, premier insert et deuxième insert, de forme généralement plane, le premier insert s'interposant entre la face principale et le troisième via qui s'étend à partir du premier plot, le deuxième insert s'interposant entre la face principale et le troisième via qui s'étend à partir du deuxième plot, les troisièmes moyens comprennent en outre au moins un troisième via terminal qui s'étend du premier insert vers la face principale, et au moins un autre troisième via terminal qui s'étend du deuxième insert vers la face principale.

Selon un mode de mise en œuvre, la face support est assemblée avec une face de la couche support, dite face secondaire, opposée à la face principale de ladite couche support.

Selon un mode de mise en œuvre, le recouvrement par la couche de transfert de l'une de la première et de la deuxième surface est partiel, et laisse libre d'accès une première section et une deuxième section, respectivement, de la première surface et de la deuxième surface, un premier fil connecte directement le premier terminal et le premier plot, tandis qu'un deuxième fil connecte directement le deuxième terminal et le deuxième plot, le premier terminal et le deuxième terminal étant disposés sur le substrat support.

Selon un mode de mise en œuvre, la couche de transfert comprend deux plots métalliques secondaires, dits respectivement, premier plot secondaire et deuxième plot secondaire accessibles par une face contact de la couche de transfert en regard de la face supérieure, une première bille métallique connectant le premier plot secondaire et le premier plot, et une deuxième bille métallique connectant le deuxième plot secondaire et le deuxième plot, le premier terminal et le deuxième terminal sont disposés sur la face contact, le premier terminal et le premier plot secondaire sont connectés via une première ligne de redistribution, tandis que le deuxième terminal et le deuxième plot secondaire sont connectés via une deuxième ligne de redistribution.

Selon un mode de mise en œuvre, la face support est assemblée à la couche photonique par la face supérieure au moyen de billes métalliques assurant également la connexion électrique des premier et deuxième plots avec, respectivement le premier terminal et le deuxième terminal, le substrat support comprenant une ouverture traversante traversant le substrat support de la face support vers une face du substrat support opposée à la face support, ladite ouverture traversante étant configurée pour permettre le positionnement des premiers moyens.

Selon un mode de mise en œuvre, ledit dispositif photonique comprend des moyens de couplage configurés pour injecter un rayonnement laser émis par la source laser dans une fibre optique ou un réseau de fibres optiques.

Selon un mode de mise en œuvre, les moyens de couplage sont configurés pour permettre le couplage par une tranche, dite tranche de couplage, dudit dispositif perpendiculaire à la face principale, avantageusement les moyens de couplage comprennent une lentille associée à la tranche de couplage.

Selon un mode de mise en œuvre, les moyens de couplage comprennent un réseau de diffraction disposé dans la couche photonique et configuré pour permettre un couplage optique par la face supérieure du rayonnement laser émis par le source laser et un fibre optique ou un réseau de fibres optiques.

### Brève description des dessins

D'autres caractéristiques et avantages de l'invention ressortiront de la description détaillée qui va suivre en référence aux figures annexées sur lesquelles :
[Fig.1] La [Fig.1] est une représentation schématique d'un dispositif photonique pourvu d'une source faite de matériau semi-conducteur III-V connue de l'état de la technique ;
[Fig.2A] La [Fig.2A] est une représentation schématique d'un dispositif photonique selon un premier mode de réalisation de la présente invention et pour lequel seuls les premiers moyens sont représentés, le dispositif photonique est notamment représenté selon un plan de coupe perpendiculaire à la face principale ;
[Fig.2B] La [Fig.2B] est une représentation schématique d'un dispositif photonique selon un premier mode de réalisation de la présente invention, et pour lequel les premiers, les deuxièmes et les troisièmes moyens sont représentés, le dispositif photonique est notamment représenté selon un plan de coupe perpendiculaire à la face principale ;
[Fig.3] La [Fig.3] est une représentation schématique d'un exemple de dispositif photonique conforme au mode de réalisation représenté à la [Fig.1], la [Fig.3] est notamment simplifiée pour des raisons de clarté, en particulier dans cet exemple, la couche photonique est formée par un empilement d'une première couche, d'une deuxième couche et d'une troisième couche, le dispositif photonique est notamment représenté selon un plan de coupe perpendiculaire à la face principale ;
[Fig.4] La [Fig.4] est une représentation schématique d'un empilement photonique susceptible d'être mis en œuvre dans un dispositif photonique selon la présente invention, par souci de clarté, l'empilement photonique est représenté isolé dudit dispositif photonique et selon un plan de coupe perpendiculaire à la face principale ;
[Fig.5] La [Fig.5] est une représentation schématique d'un guide d'onde susceptible d'être mis en œuvre dans un dispositif photonique selon la présente invention, par souci de clarté, le guide d'onde est représenté isolé dudit dispositif photonique et selon un plan de coupe perpendiculaire à la face principale ;
[Fig.6] La [Fig.6] est une représentation simplifiée du dispositif de la [Fig.1] détaillant l'agencement des deuxièmes moyens ;
[Fig.7] La [Fig.7] est une représentation simplifiée du dispositif de la [Fig.1] détaillant l'agencement des troisièmes moyens;
[Fig.8] La [Fig.8] est une représentation schématique et simplifiée d'un dispositif photonique pourvu de moyens de couplage selon un deuxième exemple, le dispositif photonique est notamment représenté selon un plan de coupe perpendiculaire à la face principale ;
[Fig.9] La [Fig.9] est une représentation schématique et simplifiée d'un dispositif photonique pourvu de moyens de couplage selon un premier exemple, le dispositif photonique est notamment représenté selon un plan de coupe perpendiculaire à la face principale ;
[Fig. 10] La [Fig.10] est une vue par la face avant d'un dispositif photonique pourvu d'une pluralité de sources laser et d'un premier moyen commun à toutes les sources laser ;
[Fig.11] La [Fig.11] représente un dispositif photonique conforme à la présente invention et qui comprend une puce de pilotage ;
[Fig.12] La [Fig.12] est une représentation schématique d'un dispositif photonique selon un deuxième mode de réalisation de la présente invention, le dispositif photonique est notamment représenté selon un plan de coupe perpendiculaire à la face principale ;
[Fig.13] La [Fig.13] est une représentation schématique d'un dispositif photonique selon un troisième mode de réalisation de la présente invention, le dispositif photonique est notamment représenté selon un plan de coupe perpendiculaire à la face principale.

### DESCRIPTION DETAILLEE DE L'INVENTION

La présente invention concerne un dispositif photonique et plus particulièrement un dispositif photonique qui comprend une puce photonique pourvue d'une source laser hétérogène et des moyens de dissipation thermique configurés pour dissiper la chaleur susceptible d'être émise par la source laser.

Plus particulièrement, la présente invention concerne un dispositif photonique qui comprend une puce photonique et un substrat support, la puce photonique comprenant une couche support, et une couche photonique. Notamment, la couche photonique repose, par sa face inférieure, sur une face principale de la couche support. Par ailleurs, la couche photonique, qui comprend au moins un matériau diélectrique, encapsule une source laser formée par un guide d'onde et un empilement photonique optiquement couplés entre eux.

La puce photonique comprend également un premier plot et un deuxième plot présentant, respectivement, une première surface et une deuxième surface, accessibles par une face supérieure de la couche photonique opposée à la couche inférieure. A cet égard, le premier plot et le deuxième plot sont électriquement connectés à l'empilement photonique au moyen de vias de connexion qui s'étendent dans la couche photonique.

En outre, les moyens de dissipation thermique comprennent des premiers moyens configurés pour dissiper de la chaleur susceptible d'être émise par la source laser.

Plus particulièrement, les premiers moyens comprennent une couche de transfert et un élément de transfert exclusivement au contact de la couche de transfert. La couche de transfert comprend notamment un matériau électriquement isolant qui est en recouvrement partiel d'au moins l'une de la première et de la deuxième surface, laissant libre d'accès une première section et une deuxième section, respectivement, de la première et de la deuxième surface.

Cet agencement particulier de la couche de transfert permet ainsi de connecter électriquement, avec des moyens de connexion, la première et la deuxième section avec les pistes métalliques du substrat support au niveau d'une face support dudit substrat.

Les moyens de dissipation thermique peuvent également comprendre des deuxièmes et des troisièmes moyens configurés pour dissiper de la chaleur susceptible d'être émise par la source laser.

Les deuxièmes et les troisièmes moyens comprennent, respectivement, des seconds et des troisièmes vias qui s'étendent, en direction de la face principale, et à partir, respectivement, du guide d'onde, et de l'un et/ou l'autre du premier plot et du deuxième plot.

A la [Fig.2A], on peut voir un dispositif photonique 100 selon un premier mode de réalisation de la présente invention. Le dispositif photonique 100 comprend une puce photonique 101 qui comprend, d'une face arrière 100B vers une face avant 100A, une couche support 200 et une couche photonique 300. Le dispositif photonique 100 comprend également un substrat support 210 pourvu de deux faces parallèles dites, respectivement, face support 210A et face libre 210B. Plus particulièrement, le substrat support 210 comprend, sur sa face support 210A un premier terminal 211 et un deuxième terminal 212. Plus particulièrement, le premier terminal 211 et le deuxième terminal 212 sont configurées pour permettre le contrôle et/ou l'interfaçage du dispositif photonique 100 avec des moyens de contrôle. A cet égard, le premier terminal 211 et le deuxième terminal 212, accessibles par la face support, se prolongent selon l'épaisseur du substrat support 210 au moyen respectivement, d'un premier via 211A et d'un deuxième via 212A. Le premier via 211A et la deuxième via 212B étant agencés pour permettre une connexion électrique par la face libre 210B. Par exemple, un plot 211B et un plot 212B peuvent être disposés sur la face libre 210B, dans le prolongement, respectivement, du premier via 211B et du deuxième via 212B.

La couche support 200 comprend deux faces, parallèles entre elles, dites, respectivement, face principale 200A et face secondaire 200B, tandis que la couche photonique 300 comprend également deux faces parallèles avec la face principale 200A et dites, respectivement, face inférieure 300A et face supérieure 300B. A cet égard, et tel qu'illustré à la [Fig.2A], la couche photonique 300 repose sur la face principale 200A par sa face inférieure 300A, tandis que la couche support repose sur la face support 210A par sa face secondaire 200B.

La couche support 200 peut comprendre un matériau semi-conducteur et plus particulièrement un matériau semi-conducteur monocristallin. A cet égard, la couche support 200 peut avantageusement comprendre du silicium monocristallin. Ce dernier matériau est connu pour être compatible avec les lignes de fabrication de composants microélectroniques et/ou photoniques et présente un coefficient de dissipation thermique élevé dont l'avantage sera évoqué dans la suite de l'énoncé de la présente invention.

La couche photonique 300 comprend au moins une couche de matériau diélectrique et dans laquelle sont encapsulés un guide d'onde 400 et un empilement photonique 500. Plus particulièrement, l'empilement photonique 500 comprend une pluralité de couches de matériaux semi-conducteurs III-V, et est optiquement couplé avec le guide d'onde 400 de manière à former avec ce dernier une source laser hétérogène. Plus particulièrement, l'empilement photonique 500 peut comprendre une pluralité de couches de matériaux semi-conducteurs III-V structurées en un deuxième guide d'onde qui est optiquement couplé au guide d'onde 400.

En d'autres termes, un rayonnement laser susceptible d'être émis par l'empilement photonique 500 sera couplé au guide d'onde 400 et guidé par ce dernier.

Ainsi, et à titre d'exemple et tel qu'illustré à la [Fig.4] (la [Fig.4] représentant l'empilement photonique isolé du reste du dispositif photonique), l'empilement photonique 500 peut comprendre, de la face avant 100A vers la face arrière 100B, une couche supérieure 501, une ou plusieurs couches de puits quantiques 502, et une couche inférieure 503. Notamment, la couche supérieure 501 peut comprendre un matériau semi-conducteur III-V dopé P, tandis que la couche inférieure 503 peut comprendre un matériau semi-conducteur III-V dopé N. Plus particulièrement, la couche supérieure 501 et la couche inférieure 503 peuvent comprendre de l'InP dopé, respectivement, P et N. La ou les couches de puits quantiques 502 peuvent comprendre un ou des matériaux semi-conducteurs III-V, par exemple des matériaux à base d'InP.

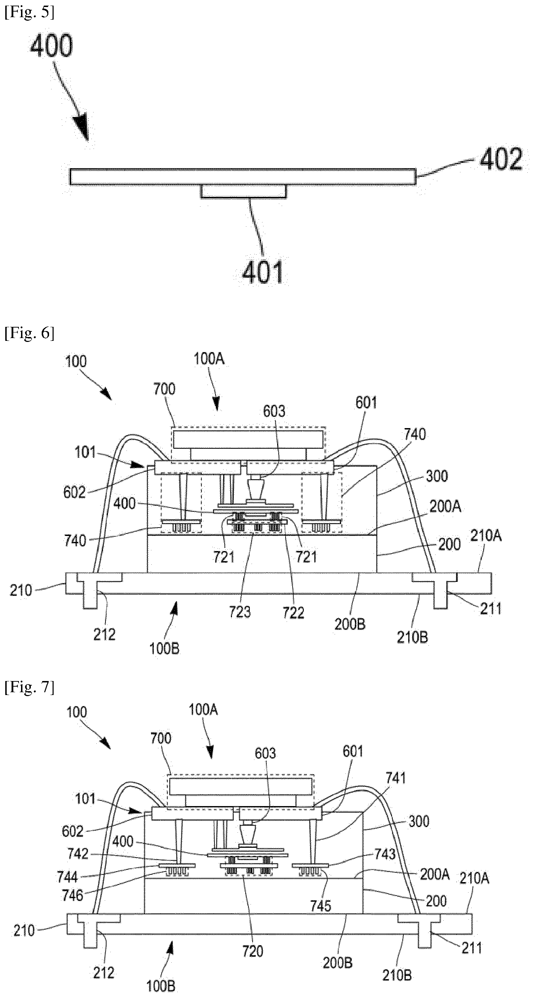

Par ailleurs, l'empilement photonique 500 est avantageusement disposé à l'aplomb du guide d'onde 400. Quant au guide d'onde 400, tel qu'illustré à la [Fig.5] (la [Fig.5] représentant le guide d'onde isolé du reste du dispositif photonique), il peut comprendre une nervure centrale 401 et une base 402 reposant sur ladite nervure centrale 401 de manière à présenter un profil en « T » selon un plan de coupe perpendiculaire à la première face. Ce dernier aspect n'a pas pour vocation à limiter la portée de la présente invention à cette unique géométrie, et l'homme du métier pourra concevoir un guide d'onde d'un profil différent. Par exemple, il peut être envisagé de considérer un guide de section carrée voire rectangulaire.

Il est par ailleurs entendu que le matériau formant le guide d'onde 400 présente un indice de réfraction supérieur à celui du matériau diélectrique formant la couche photonique 300.

La puce photonique 101 comprend également deux plots de contact, dits premier plot 601 et deuxième plot 602. Plus particulièrement, le premier plot 601 et le deuxième plot 602 présentent, respectivement, une première surface 601A et une deuxième surface 602A, accessibles par la face supérieure 300B de la couche photonique 300. Notamment, le premier plot 601 et le deuxième plot 602 sont électriquement connectés à l'empilement photonique 500 au moyen de vias de connexion 603, 604 qui s'étendent dans la couche photonique 300.

A titre d'exemple, les plots de contact peuvent comprendre de l'aluminium et présenter une épaisseur de l'ordre de 3 µm.

Par « accessible par la face supérieure », on entend un plot de contact qui présente une surface (la première surface et la deuxième surface) en affleurement ou en projection avec rapport à la face supérieure. Il est par ailleurs entendu, sans qu'il soit nécessaire de le préciser, que la première surface et la deuxième surface sont parallèles, ou à tout le moins essentiellement parallèles, à la face principale 200A. Il résulte de ce dernier aspect que la première surface et la deuxième surface sont parallèles entre elles.

Le premier plot 601 peut être connecté à la couche supérieure 501 de l'empilement photonique 500 au moyen d'un via de connexion dit premier via contact 603, tandis que le deuxième plot 602 peut être connecté à la couche inférieure 503 de l'empilement photonique 500 au moyen d'un autre via de connexion dit deuxième via contact 604.

Il est entendu que les plots de contact 601, 602 ainsi que les vias de connexion 603, 604, comprennent un matériau électriquement conducteur, plus particulièrement un métal, par exemple de l'aluminium et/ou du cuivre.

Les plots de contact 601, 602 ainsi que les vias de connexion 603, 604, tels que précédemment décrits, permettent d'imposer la circulation d'un courant au sein de l'empilement photonique 500, et par voie de conséquence, l'émission par ce dernier d'un rayonnement laser. Le rayonnement laser émis est alors couplé puis guidé par le guide d'onde 400.

Il est connu que la source laser formée par le guide d'onde 400 et l'empilement photonique 500 est susceptible de subir un échauffement lorsqu'elle est en fonctionnement. Cet échauffement peut altérer le fonctionnement de la source laser et ultimement en dégrader les performances.

Ainsi, la présente invention met également en œuvre des premiers moyens 700 de dissipation thermique configurés pour dissiper de la chaleur susceptible d'être émise par la source laser ([Fig.2A]).

De manière avantageuse, la présente invention peut également mettre en œuvre des deuxièmes moyens 720 et des troisièmes moyens 740 de dissipation thermique configurés pour dissiper de la chaleur susceptible d'être émise par la source laser ( [Fig.2B]).

A cet égard, les premiers moyens 700 comprennent une couche de transfert 701 thermique et un élément de transfert 702 thermique.

Selon ce premier mode de réalisation, la couche de transfert 701 comprend un matériau électriquement isolant qui est en recouvrement partiel d'au moins l'une de la première surface 601A et de la deuxième surface 602A, laissant libre d'accès une première section 601B et une deuxième section 602B, respectivement, de la première surface 601A et de la deuxième surface 602A.

Il est donc entendu que lorsque la couche de transfert 701 est au contact d'un plot de contact, elle est en recouvrement de la première et/ou de la deuxième surface du plot considéré, et ce recouvrement n'est que partiel de manière à permettre une reprise de contact au niveau de la première section 601B et de la deuxième section 602B, par exemple au moyen d'un fil soudé.

Notamment, le dispositif photonique 100 comprend également des fils de connexion dits, respectivement, premier fil 605 et deuxième fil 606. Plus particulièrement, le premier fil 605 connecte directement la première section 601B avec le premier terminal 211, tandis que le deuxième fil 606 connecte directement la deuxième section 602B avec le deuxième terminal 212.

De manière avantageuse, la couche de transfert est faite d'un matériau, dit matériau de transfert, qui présente une conductibilité thermique supérieure ou égale à 20 W/ m/K, par exemple une couche de transfert d'une épaisseur de 150 µm d'une conductibilité thermique égale à 130 W/m/K pourra être considérée.

Notamment, le matériau de transfert peut comprendre un matériau diélectrique vendu par la société T-global^{™} vendu sous la référence Thermal Tape.

Le choix du matériau de transfert est accessible à l'homme du métier.

La matériau de transfert présente également une résistivité électrique supérieure à 10 ¹² Ohm.cm.

A titre d'exemple, l'épaisseur de la couche de transfert peut être de 0,15 µm. Toutefois, l'homme du métier pourra ajuster l'épaisseur de la couche de transfert en fonction de la résistivité du matériau considéré.

L'élément de transfert thermique 702 est, avantageusement, exclusivement au contact de la couche de transfert thermique 701. En d'autres termes l'élément de transfert 702 se trouve électriquement isolé de l'un et l'autre du premier plot 601 et du deuxième plot 602.

L'élément de transfert thermique peut comprendre au moins un des éléments choisis parmi : une plaque métallique, une plaque de refroidissement par effet thermoélectrique, un radiateur refroidi par air, une plaque pourvue de conduits de refroidissement (par exemple des conduits permettant la circulation d'un fluide, notamment de l'eau).

L'invention n'est toutefois pas limitée à ces seuls éléments, et l'homme du métier pourra mettre en œuvre tout autre type d'élément de refroidissement susceptible de convenir.

De manière avantageuse, l'élément de transfert 702 peut être configuré pour être thermalisable.

Par « thermalisable », on entend un élément de transfert thermique susceptible de se voir imposer une température donnée.

Selon un exemple illustré à la [Fig.3], la couche photonique 300 comprend, à partir de la face principale 200A, une première couche 301, une deuxième couche 302 et une troisième couche 303. Plus particulièrement, et toujours selon cet exemple, le guide d'onde 400 est disposé dans la première couche et en affleurement avec l'interface, dite première interface 301A, formée entre la première couche 301 et la deuxième couche 302, tandis que l'empilement photonique 500 est disposé dans la troisième couche 303 et en affleurement avec l'interface, dite deuxième interface 303A, formée entre la deuxième couche 302 et la troisième couche 303.

Il est par ailleurs notable que la deuxième couche 302 est optionnelle.

Ainsi, dès lors que la source laser est en fonctionnement, la chaleur émise par cette dernière est drainée par les vias de connexion 603, 604 et les plots de contact vers les premiers moyens 700 de dissipation thermique et notamment vers la plaque de dissipation 702. La considération d'une couche de transfert thermique faite d'un matériau électriquement isolant permet de considérer une dissipation de la chaleur par coopération avec l'un et l'autre du premier plot et du deuxième plot.

Ainsi, les premiers moyens, tels que considérés dans la présente invention, permettent de limiter l'échauffement de la source laser lorsque cette dernière est en fonctionnement. Plus particulièrement, lors de la seule mise en œuvre des premiers moyens, les inventeurs ont pu observer une différence de température entre la source laser et la plaque de dissipation thermique inférieure à 10°C, alors que sans la mise en œuvre des premiers moyens, une différence de température entre le substrat support 200 et la source laser comprise entre 20°C et 30°C serait observée. La limitation et/ou le contrôle de l'échauffement de la source laser selon les principes de la présente invention permet d'améliorer le stabilité de ladite source laser.

Tel qu'illustré à la [Fig.2B], le dispositif photonique 100 peut également comprendre des deuxièmes moyens 720 configurés pour dissiper de la chaleur susceptible d'être émise par la source laser vers la couche support 200.

Les deuxièmes moyens 720 comprennent des seconds vias 721 qui s'étendent du guide d'onde 400 vers la face principale 200A. Plus particulièrement, les seconds vias 721 s'étendent dans la première couche 301 si elle est considérée ([Fig.6]).

De manière complémentaire, les deuxièmes moyens 721 peuvent également comprendre un insert métallique 722 de forme généralement plane et s'interposant entre les seconds vias 721 et la face principale 200A. Les deuxièmes moyens 720 peuvent également comprendre des seconds vias terminaux 723 qui s'étendent de l'insert métallique 722 vers la face principale 200A.

Il est entendu que l'intégralité des éléments formant les deuxièmes moyens de dissipation thermique peuvent comprendre un matériau électriquement conducteur, et notamment un métal, par exemple du cuivre. Il est entendu sans qu'il soit nécessaire de le préciser que les seconds via, l'insert métallique et les seconds via terminaux sont connectés entre eux.

Ainsi, lorsque de la chaleur est émise par la source laser, cette dernière est dissipée au moyen des premiers moyens 700 et des deuxièmes moyens 720. A cet égard, les deuxièmes moyens 720 permettent de dissiper la chaleur dans la couche support 200. La mise en œuvre des premiers moyens et des deuxièmes moyens permet d'observer une différence de température entre la source laser et la plaque de dissipation thermique inférieure à 8°C. La seule mise en œuvre des deuxièmes moyens ne permettrait d'observer une différence de température entre le substrat 200 et la source laser de 13°C à 17°C.

Tel qu'illustré à la [Fig.2B], le dispositif photonique 100 comprend également des troisièmes moyens 740 configurés pour dissiper de la chaleur susceptible d'être émise par la source laser vers la couche support 200. Les troisièmes moyens 740 comprenant des troisièmes vias 741, 742 qui s'étendent à partir, respectivement, du premier plot 601 et du deuxième plot 602 vers la face principale 200A ([Fig.7]).

Les troisièmes moyens 740 comprennent également deux inserts métalliques dits, respectivement, premier insert 743 et deuxième insert 744, de forme généralement plane. Le premier insert 743, est au contact du troisième via 741 qui s'étend à partir du premier plot 601, et s'interpose entre la face principale 200A et ledit troisième via 741. Le deuxième insert 744 est au contact du troisième via 742 qui s'étend à partir du deuxième plot 602 et s'interpose entre la face principale 200A et ledit troisième via 742.

De manière avantageuse, l'insert métallique 722, le premier insert 743 et deuxième insert 744 sont formés à partir d'un unique niveau métallique. En d'autres termes, la distance séparant un insert de la face principale est la même pour chacun des inserts.

Les troisièmes moyens 740 peuvent en outre comprendre un ou plusieurs troisièmes vias terminaux 745 qui s'étendent du premier insert 743 vers la face principale 200A, et un ou plusieurs autres troisièmes vias terminaux 746 qui s'étendent du deuxième insert 744 vers la face principale 200A.

Il est entendu que l'intégralité des éléments formant les troisièmes moyens 740 peuvent comprendre un matériau électriquement conducteur, et notamment un métal, par exemple du cuivre.

Ces troisièmes moyens 740 pris en combinaison avec les premiers moyens et les deuxièmes moyens permettent d'observer une différence de température entre la source laser et la plaque de dissipation thermique inférieure à 7°C.

Le dispositif photonique 100 peut également comprendre des moyens de couplage configurés pour injecter un rayonnement laser émis par la source laser dans une fibre optique ou un réseau de fibres optiques.

Selon un premier exemple, les moyens de couplage sont configurés pour permettre le couplage par une tranche, dite tranche de couplage 200C, dudit dispositif perpendiculaire à la face principale 200A. Cet aspect est illustré à la [Fig.8]. De manière avantageuse, les moyens de couplage comprennent un guide d'onde 804, une lentille 800 associée à la tranche de couplage 200C. Ces moyens de couplage permettent ainsi de coupler le rayonnement lumineux émis par la source laser à un dispositif externe, par exemple, à un réseau de fibres optiques 801.

Selon un deuxième exemple, les moyens de couplage comprennent un réseau de diffraction 803 disposé dans la couche photonique et configuré pour permettre un couplage optique par la face avant du rayonnement laser émis par le source laser et un fibre optique ou un réseau de fibres optiques. Cet aspect est illustré à la [Fig.9].

L'invention n'est évidemment pas limitée à une unique source laser. A cet égard, l'homme du métier, tel qu'illustré à la [Fig.10], pourra considérer un dispositif photonique 100 pourvu d'une pluralité de puces photoniques 101, et une couche de transfert thermique au contact des premier et deuxième plot 601 et 602. Selon cette configuration, les tranches de couplage de chacune des puces photoniques 101 peuvent être coplanaires. Par ailleurs les premiers terminaux 211 et les deuxièmes terminaux 212, disposés sur la face support 210A, sont en regard d'une face des puces photoniques opposée à la tranche de couplage 200C.

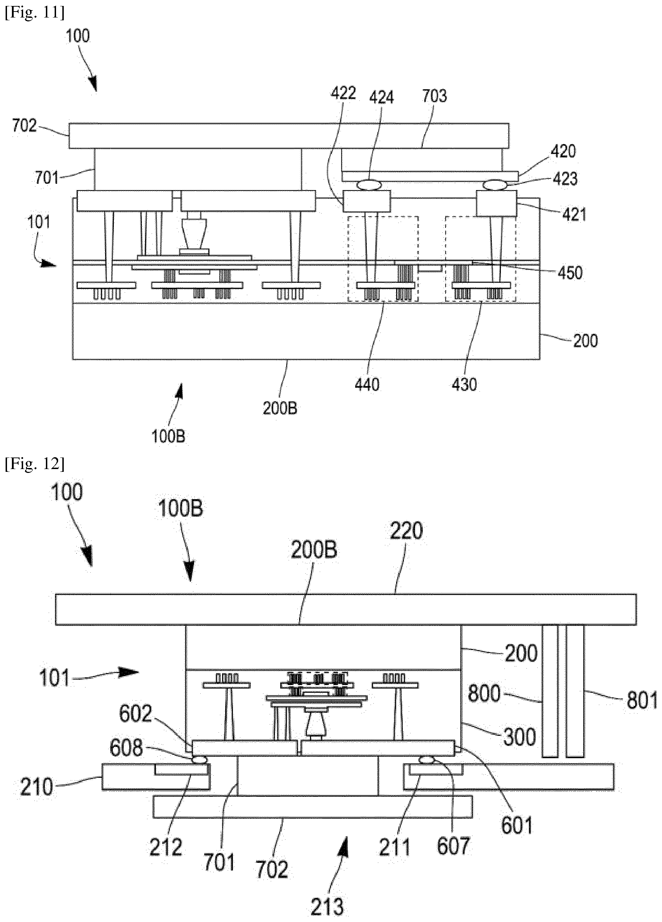

Tel qu'illustré à la [Fig.11], la dispositif photonique 100 peut également comprendre un puce de pilotage 420 et un modulateur 450 (ce dernier comprend notamment un guide d'onde encapsulé dans la couche photonique). La puce de pilotage 420 repose notamment sur deux plots connecteurs 421 et 422 accessibles par la face avant 100A. Des billes métalliques 423, 424 peuvent venir s'interposer entre les plots connecteurs et la face avant. Le dispositif photonique 100 peut comprendre une couche de dissipation thermique auxiliaire 703 couplant thermiquement la puce de pilotage avec la plaque de dissipation thermique 702. La couche de dissipation thermique auxiliaire 703 est faite du même matériau que la couche de dissipation thermique 701.

Le dispositif photonique 100 comprend également d'autres moyens de dissipation thermique 430 et 440 qui reprennent pour l'essentiel les caractéristiques des deuxièmes et des troisièmes moyens de dissipation afin de dissiper la chaleur susceptible d'être générée au niveau de la puce de pilotage 420 et du modulateur 450.

A la [Fig.12], on peut voir le dispositif photonique 100 selon un deuxième mode de réalisation de la présente invention qui reprend pour l'essentiel les éléments relatifs au premier mode de réalisation.

Selon ce deuxième mode de réalisation, la face support est assemblée à la couche photonique par la face supérieure au moyen de billes métalliques 607, 608 assurant également la connexion électrique des premier 601 et deuxième 602 plots avec le premier terminal 211 et le deuxième terminal 212. Le substrat support 210 comprend, selon ce deuxième mode de réalisation, une ouverture traversante 213 traversant le substrat support de la face support vers la face libre, ladite ouverture traversante étant configurée pour permettre le positionnement des premiers moyens 700.

Le dispositif photonique 100 selon ce deuxième mode de réalisation peut également comprendre un substrat additionnel 220 sur une face duquel est assemblée la face secondaire 200B de la couche support 200 ainsi que le lentille 800 et le réseau de fibres optiques 801.

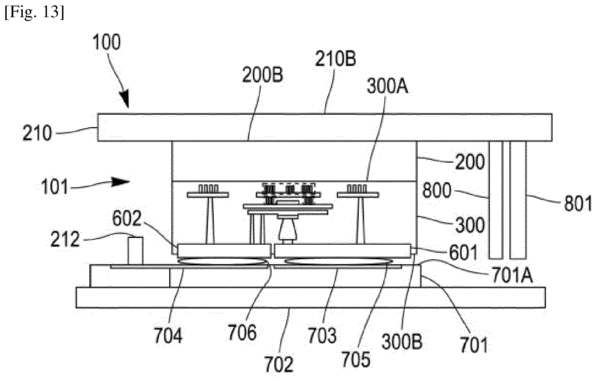

A la [Fig.13], on peut voir le dispositif photonique 100 selon un troisième mode de réalisation de la présente invention qui reprend pour l'essentiel les éléments relatifs au premier mode de réalisation.

Selon ce troisième mode de réalisation, la couche de transfert 701 comprend deux plots métalliques secondaires, dits respectivement, premier plot secondaire 703 et deuxième plot secondaire 704 accessibles par une face contact 701A de la couche de transfert 701 en regard de la face supérieure 300B.

Une première bille métallique 705, par exemple faite de AuSn, connecte le premier plot secondaire 703 et le premier plot 601, et une deuxième bille métallique 706 connecte le deuxième plot secondaire 704 et le deuxième plot 602.

Le premier terminal 211 et le deuxième terminal 212 (non représenté sur la [Fig.13] par souci de clarté) sont électriquement liés, respectivement, au premier plot secondaire 703 et au deuxième plot secondaire 704 via des lignes de redistribution.

Selon ce troisième mode de réalisation, le couche de transfert 701 comprend avantageusement du silicium ou encore de l'AlN. Ces deux matériaux sont particulièrement adaptés pour la formation de moyens de connexion, de lignes de redistribution.

La présente invention propose donc une solution efficace pour dissiper la chaleur susceptible d'être émise par un laser en fonctionnement et ainsi en assurer la stabilité. Notamment, la présente invention propose de mettre en œuvre des premiers moyens permettant de dissiper la chaleur susceptible d'être produite par la source laser qui coopèrent avec des moyens de connexion de ladite source laser.

Un procédé de fabrication du dispositif photonique peut faire intervenir des étapes de fabrication bien connues dans le domaine de la microélectronique.

Bien sûr, l'invention n'est pas limitée aux modes de réalisation décrits et on peut y apporter des variantes de réalisation sans sortir du cadre de l'invention tel que défini par les revendications.

### références

[1] S. Menezo et al., "Back-Side-On-BOX heterogeneous laser integration forfully integrated photonic circuits on silicon" 45th European Conference on Optical Communication (ECOC 2019), 2019, pp. 1-3 ;
[2] M. N. Sysak et al., "Hybrid Silicon Laser Technology: A Thermal Perspective" in IEEE Journal of Selected Topics in Quantum Electronics, vol. 17, no. 6, pp. 1490-1498, Nov.-Dec. 2011 ;
[3] C. Zhang et al., "Thermal Management of Hybrid Silicon Ring Lasers for High Temperature Operation" in IEEE Journal of Selected Topics in Quantum Electronics, vol. 21, no. 6, pp. 385-391, Nov.-Dec. 2015 ;
[4] US 2014/0376857 A1.

## Revendications

1. Dispositif photonique (100) comprenant une puce photonique (101) et un substrat support (210), le substrat support (210) étant pourvu d'une face support (210A), la puce photonique (101) comprenant une couche support (200) et une couche photonique (300) reposant par sa face, dite inférieure (300A), sur une face principale (200A) de la couche support (200), ladite couche photonique (300), qui comprend au moins un matériau diélectrique, encapsule au moins une source laser formée par un guide d'onde (400) et un empilement photonique (500) optiquement couplés entre eux, l'empilement photonique étant constitué de matériaux semi-conducteurs III-V, la puce photonique comprend également un premier (601) et un deuxième (602) plot métallique présentant, respectivement, une première (601A) et une deuxième (602A) surface, accessibles par une face supérieure (300B) de la couche photonique (300) opposée à la face inférieure (300A), et électriquement connectés à l'empilement photonique (500) au moyen de vias de connexion (603, 604) qui s'étendent dans la couche photonique (300), le premier plot (601) et le deuxième plot (602) sont configurés pour permettre la circulation d'un courant électrique dans l'empilement photonique (500) afin de commander l'émission d'un rayonnement laser par la source laser, le dispositif photonique comprend en outre :
- des premiers moyens (700) de dissipation thermique configurés pour dissiper la chaleur susceptible d'être émise par la source laser, les premiers moyens (700) comprennent une couche de transfert (701) et un élément de transfert (702) en contact thermique avec la couche de transfert (701),
**caractérisé en ce que**
la couche de transfert (701) comprend un matériau électriquement isolant qui est en recouvrement au moins partiel d'au moins l'une de la première et de la deuxième surface (601A, 602A) ;
- des moyens de connexion configurés pour connecter électriquement le premier plot (601) et le deuxième plot (602) avec un premier terminal (211) et un deuxième terminal (212) disposés sur l'un ou l'autre du substrat support (210) et de la couche de transfert (701).

2. Dispositif photonique (100) selon la revendication 1, dans lequel la couche de transfert (701) est au contact du premier plot (601) et du deuxième plot (602).

3. Dispositif photonique (100) selon la revendication 1 ou 2, dans lequel la couche de transfert (701) est faite d'un matériau, dit matériau de transfert, qui présente une conductibilité thermique supérieure ou égale à 20 W/m/K, la couche de transfert (701) comprenant avantageusement au moins un des matériaux choisis parmi : un matériau polymère, de l'AlN ou du silicium.

4. Dispositif photonique (100) selon l'une des revendications 1 à 3, dans lequel le guide d'onde (400) est en silicium, ou en nitrure de silicium ou de forme hybride en nitrure de silicium et en silicium.

5. Dispositif photonique (100) selon l'une des revendications 1 à 4, dans lequel ledit dispositif photonique comprend également des deuxièmes moyens (720) configurés pour dissiper de la chaleur susceptible d'être émise par la source laser vers la couche support (200), les deuxièmes moyens (720) comprennent des seconds vias (721) qui s'étendent, en direction de la face principale (200A), et à partir du guide d'onde (400).

6. Dispositif photonique (100) selon la revendications 5, dans lequel les deuxièmes moyens (720) comprennent également un insert métallique (722) de forme généralement plane et s'interposant entre les seconds vias (721) et la face principale (200A), les deuxièmes moyens comprennent en outre des seconds vias terminaux (723) qui s'étendent de l'insert métallique (722) vers la face principale (200A), un insert additionnel est avantageusement intercalé entre la face principale et les seconds vias terminaux.

7. Dispositif photonique (100) selon l'une des revendications 1 à 6, dans lequel ledit dispositif photonique comprend également des troisièmes moyens (740) configurés pour dissiper de la chaleur susceptible d'être émise par la source laser, les troisièmes moyens (740) comprennent des troisièmes vias (741, 742) qui s'étendent, en direction de la face principale (200A), et à partir, respectivement, du premier plot (601) et du deuxième plot (602).

8. Dispositif photonique (100) selon la revendication 7, dans lequel les troisièmes moyens (740) comprennent également deux inserts métalliques dits, respectivement, premier insert (743) et deuxième insert (744), de forme généralement plane, le premier insert (743) s'interposant entre la face principale (200A) et le troisième via (741) qui s'étend à partir du premier plot (601), le deuxième insert (744) s'interposant entre la face principale (200A) et le troisième via (742) qui s'étend à partir du deuxième plot (602), les troisièmes moyens (740) comprennent en outre au moins un troisième via terminal (745) qui s'étend du premier insert (743) vers la face principale (200A), et au moins un autre troisième via terminal (746) qui s'étend du deuxième insert (744) vers la face principale (200A).

9. Dispositif photonique (100) selon l'une des revendications 1 à 8, dans lequel la face support (210A) est assemblée avec une face de la couche support (200), dite face secondaire (200B), opposée à la face principale (200A) de ladite couche support.

10. Dispositif photonique (100) selon la revendication 9, dans lequel le recouvrement par la couche de transfert (701) de l'une de la première et de la deuxième surface (601A, 602A) est partiel, et laisse libre d'accès une première section (601B) et une deuxième section (602B), respectivement, de la première surface (601A) et de la deuxième surface (602A), un premier fil (605) connecte directement le premier terminal (211) et le premier plot (601), tandis qu'un deuxième fil (606) connecte directement le deuxième terminal (212) et le deuxième plot (602), le premier terminal (211) et le deuxième terminal (212) étant disposés sur le substrat support (210).

11. Dispositif photonique (100) selon la revendication 9, dans lequel la couche de transfert (701) comprend deux plots métalliques secondaires, dits respectivement, premier plot secondaire (703) et deuxième plot secondaire (704) accessibles par une face contact (701A) de la couche de transfert (701) en regard de la face supérieure (300B), une première bille métallique (705) connectant le premier plot secondaire (703) et le premier plot (601), et une deuxième bille métallique (706) connectant le deuxième plot secondaire (704) et le deuxième plot (602), le premier terminal (211) et le deuxième terminal (212) sont disposés sur la face contact (701A), le premier terminal (211) et le premier plot secondaire (703) sont connectés via une première ligne de redistribution, tandis que le deuxième terminal (212) et le deuxième plot secondaire (704) sont connectés via une deuxième ligne de redistribution.

12. Dispositif photonique (100) selon l'une des revendications 1 à 8, dans lequel la face support est assemblée à la couche photonique par la face supérieure au moyen de billes métalliques (607, 608) assurant également la connexion électrique des premier et deuxième plots avec, respectivement le premier terminal et le deuxième terminal, le substrat support comprenant une ouverture traversante (213) traversant le substrat support de la face support vers une face du substrat support opposée à la face support, ladite ouverture traversante étant configurée pour permettre le positionnement des premiers moyens.

13. Dispositif photonique (100) selon l'une des revendications 1 à 12, dans lequel ledit dispositif photonique (100) comprend des moyens de couplage configurés pour injecter un rayonnement laser émis par la source laser dans une fibre optique ou un réseau de fibres optiques.

14. Dispositif photonique (100) selon la revendication 13, dans lequel les moyens de couplage sont configurés pour permettre le couplage par une tranche, dite tranche de couplage (200C), dudit dispositif perpendiculaire à la face principale (200A), avantageusement les moyens de couplage comprennent une lentille (800) associée à la tranche de couplage.

15. Dispositif photonique (100) selon la revendication 13, dans lequel les moyens de couplage comprennent un réseau de diffraction (803) disposé dans la couche photonique (300) et configuré pour permettre un couplage optique par la face supérieure du rayonnement laser émis par le source laser et un fibre optique ou un réseau de fibres optiques.

## Patentansprüche

1. Photonische Vorrichtung (100), umfassend einen photonischen Chip (101) und ein Trägersubstrat (210), wobei das Trägersubstrat (210) mit einer Trägerfläche (210A) versehen ist, der photonische Chip (101) umfassend eine Trägerschicht (200) und eine photonische Schicht (300), die mit ihrer sogenannten unteren Fläche (300A) auf einer Hauptfläche (200A) der Trägerschicht (200) aufliegt, wobei die photonische Schicht (300), die mindestens ein dielektrisches Material umfasst, mindestens eine Laserquelle einkapselt, die aus einem Wellenleiter (400) und einem photonischen Stapel (500) ausgebildet ist, die miteinander optisch gekoppelt sind, wobei der photonische Stapel aus III-V-Halbleitermaterialien besteht, wobei der photonische Chip ferner ein erstes (601) und ein zweites (602) Metallklötzchen umfasst, die jeweils eine erste (601A) und eine zweite (602A) Oberfläche aufweisen, die über eine obere Fläche (300B) der photonischen Schicht (300) gegenüber der unteren Fläche (300A) zugänglich sind und mit dem photonischen Stapel (500) mittels Verbindungsdurchkontaktierungen (603, 604) elektrisch verbunden sind, die sich in der photonischen Schicht (300) erstrecken, wobei das erste Klötzchen (601) und das zweite Klötzchen (602) zum Ermöglichen der Zirkulation eines elektrischen Stroms in dem photonischen Stapel (500) konfiguriert sind, um die Abgabe einer Laserstrahlung durch die Laserquelle zu steuern, wobei die photonische Vorrichtung ferner umfasst:
- erste Wärmeableitungsmittel (700), die zum Ableiten der Hitze konfiguriert sind, die geeignet ist, um durch die Laserquelle abgegeben zu werden, wobei die ersten Mittel (700) eine Übertragungsschicht (701) und ein Übertragungselement (702) in Wärmekontakt mit der Übertragungsschicht (701) umfassen,
**dadurch gekennzeichnet, dass:**
die Übertragungsschicht (701) ein elektrisch isolierendes Material umfasst, das mindestens teilweise mindestens eine der ersten und der zweiten Oberfläche (601A, 602A) bedeckt;
- Verbindungsmittel, die zum elektrischen Verbinden des ersten Klötzchens (601) und des zweiten Klötzchens (602) mit einem ersten Anschluss (211) und einem zweiten Anschluss (212) konfiguriert sind, die auf einem oder dem anderen des Trägersubstrats (210) und der Übertragungsschicht (701) angeordnet sind.

2. Photonische Vorrichtung (100) nach Anspruch 1, wobei die Übertragungsschicht (701) mit dem ersten Klötzchen (601) und dem zweiten Klötzchen (602) in Kontakt steht.

3. Photonische Vorrichtung (100) nach Anspruch 1 oder 2, wobei die Übertragungsschicht (701) aus einem Material hergestellt ist, genannt Übertragungsmaterial, das eine Wärmeleitfähigkeit von größer oder gleich 20 W/m/K aufweist, die Übertragungsschicht (701) umfassend vorteilhafterweise mindestens eines der folgenden Materialien, das ausgewählt ist aus: einem Polymermaterial, AIN oder Silizium.

4. Photonische Vorrichtung (100) nach einem der Ansprüche 1 bis 3, wobei der Wellenleiter (400) aus Silizium oder Siliziumnitrid oder einer Hybridform aus Siliziumnitrid und Silizium ist.

5. Photonische Vorrichtung (100) nach einem der Ansprüche 1 bis 4, wobei die photonische Vorrichtung ferner zweite Mittel (720) umfasst, die zum Ableiten der Hitze konfiguriert sind, die geeignet ist, um durch die Laserquelle in Richtung der Trägerschicht (200) abgegeben zu werden, die zweiten Mittel (720) umfassend zweite Durchkontaktierungen (721), die sich in Richtung der Hauptfläche (200A) und von dem Wellenleiter (400) aus erstrecken.

6. Photonische Vorrichtung (100) nach Anspruch 5, wobei die zweiten Mittel (720) ferner einen Metalleinsatz (722) von im Allgemeinen ebener Form umfassen, der zwischen den zweiten Durchkontaktierungen (721) und der Hauptfläche (200A) eingefügt ist, wobei die zweiten Mittel ferner zweite Anschlussdurchkontaktierungen (723) umfassen, die sich von dem Metalleinsatz (722) in Richtung der Hauptfläche (200A) erstrecken, wobei vorteilhafterweise ein zusätzlicher Einsatz zwischen der Hauptfläche und den zweiten Anschlussdurchkontaktierungen eingeschoben ist.

7. Photonische Vorrichtung (100) nach einem der Ansprüche 1 bis 6, wobei die photonische Vorrichtung ferner dritte Mittel (740) umfasst, die zum Ableiten der Hitze konfiguriert sind, die geeignet ist, um durch die Laserquelle abgegeben zu werden, wobei die dritten Mittel (740) dritte Durchkontaktierungen (741, 742) umfassen, die sich in Richtung der Hauptfläche (200A) und von dem ersten Klötzchen (601) beziehungsweise von dem zweiten Klötzchen (602) aus erstrecken.

8. Photonische Vorrichtung (100) nach Anspruch 7, wobei die dritten Mittel (740) auch zwei Metalleinsätze, genannt erster Einsatz (743) beziehungsweise zweiter Einsatz (744), von im Allgemeinen ebener Form umfassen, wobei der erste Einsatz (743) zwischen der Hauptfläche (200A) und der dritten Durchkontaktierung (741) positioniert ist, die sich von dem ersten Klötzchen (601) aus erstreckt, der zweite Einsatz (744) zwischen der Hauptfläche (200A) und der dritten Durchkontaktierung (742) positioniert ist, die sich von dem zweiten Klötzchen (602) aus erstreckt, wobei die dritten Mittel (740) ferner mindestens eine dritte Anschlussdurchkontaktierung (745), die sich von dem ersten Einsatz (743) in Richtung der Hauptfläche (200A) erstreckt, und mindestens eine weitere dritte Anschlussdurchkontaktierung (746) umfassen, die sich von dem zweiten Einsatz (744) in Richtung der Hauptfläche (200A) erstreckt.

9. Photonische Vorrichtung (100) nach einem der Ansprüche 1 bis 8, wobei die Trägerfläche (210A) mit einer Fläche der Trägerschicht (200), genannt sekundäre Fläche (200B), gegenüber der Hauptfläche (200A) der Trägerschicht montiert ist.

10. Photonische Vorrichtung (100) nach Anspruch 9, wobei die Abdeckung einer der ersten und der zweiten Oberfläche (601A, 602A) durch die Übertragungsschicht (701) teilweise ist und einen Zugang zu einem ersten Abschnitt (601B) und einem zweiten Abschnitt (602B) der ersten Oberfläche (601A) beziehungsweise der zweiten Oberfläche (602A) frei lässt, wobei ein erster Draht (605) den ersten Anschluss (211) und das erste Klötzchen (601) direkt verbindet, während ein zweiter Draht (606) den zweiten Anschluss (212) und das zweite Klötzchen (602) direkt verbindet, wobei der erste Anschluss (211) und der zweite Anschluss (212) auf dem Trägersubstrat (210) angeordnet sind.

11. Photonische Vorrichtung (100) nach Anspruch 9, wobei die Übertragungsschicht (701) zwei sekundäre Metallklötzchen umfasst, genannt erstes sekundäres Klötzchen (703) beziehungsweise zweites sekundäres Klötzchen (704), die über eine Kontaktfläche (701A) der Übertragungsschicht (701) gegenüber der oberen Fläche (300B) zugänglich sind, wobei eine erste Metallkugel (705) das erste sekundäre Klötzchen (703) und das erste Klötzchen (601) verbindet und eine zweite Metallkugel (706) das zweite sekundäre Klötzchen (704) und das zweite Klötzchen (602) verbindet, wobei der erste Anschluss (211) und der zweite Anschluss (212) auf der Kontaktfläche (701A) angeordnet sind, wobei der erste Anschluss (211) und das erste sekundäre Klötzchen (703) über eine erste Umverteilungsleitung verbunden sind, während der zweite Anschluss (212) und das zweite sekundäre Klötzchen (704) über eine zweite Umverteilungsleitung verbunden sind.

12. Photonische Vorrichtung (100) nach einem der Ansprüche 1 bis 8, wobei die Trägerfläche mittels Metallkugeln (607, 608) an der photonischen Schicht durch die obere Fläche montiert ist, wobei ebenfalls die elektrische Verbindung des ersten und des zweiten Klötzchens mit dem ersten Anschluss beziehungsweise dem zweiten Anschluss sichergestellt wird, das Trägersubstrat umfassend eine Durchgangsöffnung (213), die das Trägersubstrat der Trägerfläche in Richtung einer Fläche des Trägersubstrats gegenüber der Trägerfläche durchquert, wobei die Durchgangsöffnung zum Ermöglichen der Positionierung der ersten Mittel konfiguriert ist.

13. Photonische Vorrichtung (100) nach einem der Ansprüche 1 bis 12, wobei die photonische Vorrichtung (100) Kopplungsmittel umfasst, die zum Einspeisen einer Laserstrahlung, die durch die Laserquelle abgegeben wird, in eine Lichtleitfaser oder ein Lichtleitfasernetz konfiguriert ist.

14. Photonische Vorrichtung (100) nach Anspruch 13, wobei die Kopplungsmittel zum Ermöglichen der Kopplung durch eine Scheibe, genannt Kopplungsscheibe (200C), der Vorrichtung senkrecht zu der Hauptfläche (200A) konfiguriert sind, wobei die Kopplungsmittel vorteilhafterweise eine Linse (800) umfassen, die mit der Kopplungsscheibe verknüpft ist.

15. Photonische Vorrichtung (100) nach Anspruch 13, wobei die Kopplungsmittel ein Beugungsgitter (803), das in der photonischen Schicht (300) angeordnet ist und zum Ermöglichen einer optischen Kopplung durch die obere Fläche der Laserstrahlung konfiguriert ist, die durch die Laserquelle abgegeben wird, und eine Lichtleitfaser oder ein Lichtleitfasernetz umfassen.

## Claims

1. Photonic device (100) comprising a photonic chip (101) and a support substrate (210), the support substrate (210) being provided with a support face (210A), the photonic chip (101) comprising a support layer (200) and a photonic layer (300) resting by its face, referred to as the lower face (300A), on a main face (200A) of the support layer (200), said photonic layer (300), which comprises at least one dielectric material, encapsulates at least one laser source formed by a waveguide (400) and a photonic stack (500) optically coupled together, the photonic stack being made of III-V semi-conductor materials, the photonic chip also comprises a first (601) and a second (602) metal pad having, respectively, a first (601A) and a second (602A) surface, accessible by an upper face (300B) of the photonic layer (300) opposite the lower face (300A), and electrically connected to the photonic stack (500) by means of connection vias (603, 604) that extend in the photonic layer (300), the first pad (601) and the second pad (602) are configured to allow the circulation of an electric current in the photonic stack (500) in order to control the emission of laser radiation by the laser source, the photonic device further comprises:
- first heat dissipation means (700) which are configured to dissipate the heat capable of being emitted by the laser source, the first means (700) comprising a transfer layer (701) and a transfer element (702) in thermal contact with the transfer layer (701),
**characterized in that**
the transfer layer (701) comprises an electrically insulating material which at least partially covers at least one of the first and the second surface (601A, 602A);
- connection means which are configured to electrically connect the first pad (601) and the second pad (602) with a first terminal (211) and a second terminal (212) arranged on either the support substrate (210) or the transfer layer (701).

2. Photonic device (100) according to claim 1, wherein the transfer layer (701) is in contact with the first pad (601) and the second pad (602).

3. Photonic device (100) according to claim 1 or 2, wherein the transfer layer (701) is made of a material, referred to as transfer material, which has a thermal conductivity greater than or equal to 20 W/m/K, the transfer layer (701) advantageously comprising at least one of the materials selected from: a polymer material, AIN or silicon.

4. Photonic device (100) according to one of claims 1 to 3, wherein the waveguide (400) is made of silicon, or of silicon nitride or of a hybrid form of silicon nitride and of silicon.

5. Photonic device (100) according to one of claims 1 to 4, wherein said photonic device also comprises second means (720) which are configured to dissipate the heat capable of being emitted by the laser source toward the support layer (200), the second means (720) comprise second vias (721) that extend, in the direction of the main face (200A), from the waveguide (400).

6. Photonic device (100) according to claim 5, wherein the second means (720) also comprise a metal insert (722) which is generally planar in shape and positioned between the second vias (721) and the main face (200A), the second means further comprise second terminal vias (723) that extend from the metal insert (722) toward the main face (200A), an additional insert is advantageously inserted between the main face and the second terminal vias.

7. Photonic device (100) according to one of claims 1 to 6, wherein said photonic device also comprises third means (740) which are configured to dissipate the heat capable of being emitted by the laser source, the third means (740) comprise third vias (741, 742) that extend in the direction of the main face (200A) from the first pad (601) and the second pad (602), respectively.

8. Photonic device (100) according to claim 7, wherein the third means (740) also comprise two metal inserts, referred to as first insert (743) and second insert (744), respectively, which are generally planar in shape, the first insert (743) being positioned between the main face (200A) and the third via (741) that extends from the first pad (601), the second insert (744) being positioned between the main face (200A) and the third via (742) that extends from the second pad (602), the third means (740) further comprising at least one third terminal via (745) that extends from the first insert (743) toward the main face (200A), and at least one other third terminal via (746) that extends from the second insert (744) toward the main face (200A).

9. Photonic device (100) according to one of claims 1 to 8, wherein the support face (210A) is assembled with a face of the support layer (200), referred to as the secondary face (200B), opposite the main face (200A) of said support layer.

10. Photonic device (100) according to claim 9, wherein the covering of one of the first and the second surface (601A, 602A) by the transfer layer (701) is partial, and leaves access free to a first section (601B) and a second section (602B), respectively, of the first surface (601A) and the second surface (602A), a first wire (605) directly connects the first terminal (211) and the first pad (601), while a second wire (606) directly connects the second terminal (212) and the second pad (602), the first terminal (211) and the second terminal (212) being arranged on the support substrate (210).

11. Photonic device (100) according to claim 9, wherein the transfer layer (701) comprises two secondary metal pads, referred to as first secondary pad (703) and second secondary pad (704), respectively, which are accessible by a contact face (701A) of the transfer layer (701) opposite the upper face (300B), a first metal ball (705) connecting the first secondary pad (703) and the first pad (601), and a second metal ball (706) connecting the second secondary pad (704) and the second pad (602), the first terminal (211) and the second terminal (212) are arranged on the contact face (701A), the first terminal (211) and the first secondary pad (703) are connected via a first redistribution line, while the second terminal (212) and the second secondary pad (704) are connected via a second redistribution line.

12. Photonic device (100) according to one of claims 1 to 8, wherein the support face is assembled to the photonic layer by the upper face by means of metal balls (607, 608) also ensuring the electrical connection of the first and second pads with, respectively, the first terminal and the second terminal, the support substrate comprising a through-opening (213) passing through the support substrate of the support face toward a face of the support substrate opposite the support face, said through-opening being configured to allow the positioning of the first means.

13. Photonic device (100) according to one of claims 1 to 12, wherein said photonic device (100) comprises coupling means which are configured to inject laser radiation emitted by the laser source into an optical fiber or a network of optical fibers.

14. Photonic device (100) according to claim 13, wherein the coupling means are configured to allow coupling by an edge, referred to as the coupling edge (200C), of said device perpendicular to the main face (200A), advantageously the coupling means comprise a lens (800) associated with the coupling edge.

15. Photonic device (100) according to claim 13, wherein the coupling means comprise a diffraction grating (803) arranged in the photonic layer (300) and configured to allow optical coupling by the upper face of the laser radiation emitted by the laser source and an optical fiber or a network of optical fibers.
